(19) **Europäisches Patentamt / European Patent Office / Office européen des brevets**

(11) **EP 1 990 314 B1**

(12) **EUROPÄISCHE PATENTSCHRIFT**

(45) Veröffentlichungstag und Bekanntmachung des Hinweises auf die Patenterteilung:
**21.12.2011 Patentblatt 2011/51**

(51) Int Cl.:
***C01B 33/027*** *(2006.01)*

(21) Anmeldenummer: **08155254.9**

(22) Anmeldetag: **28.04.2008**

(54) **Verfahren zur kontinuierlichen Herstellung von polykristallinem hochreinen Siliciumgranulat**

Process for the continuous production of polycrystalline high-purity silicon granules

Procédé de production continue de granulés de silicium polycristallins de pureté élévée

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **04.05.2007 DE 102007021003**

(43) Veröffentlichungstag der Anmeldung:
**12.11.2008 Patentblatt 2008/46**

(73) Patentinhaber: **Wacker Chemie AG**
**81737 München (DE)**

(72) Erfinder:
- **Weidhaus, Dieter**
  **84489 Burghausen (DE)**
- **Hauswirth, Rainer**
  **84375 Kirchdorf (DE)**
- **Hertlein, Harald**
  **84489 Burghausen (DE)**

(74) Vertreter: **Fränkel, Robert et al**
**Wacker Chemie AG**
**Zentralbereich Patente, Marken und Lizenzen**
**Hanns-Seidel-Platz 4**
**81737 München (DE)**

(56) Entgegenhaltungen:
**EP-A- 0 896 952        WO-A-2004/013044**
**WO-A-2007/028776    WO-A-2007/091834**
**WO-A-2007/094607    WO-A-2008/018760**
**DE-A1- 19 948 395    GB-A- 2 271 518**
**US-A- 5 374 413**

- **"FLUIDIZED-BED SILANE-DECOMPOSITION REACTOR" NTIS TECH NOTES, US DEPARTMENT OF COMMERCE. SPRINGFIELD, VA, US, 1. März 1992 (1992-03-01), Seite 209, XP000291054 ISSN: 0889-8464**

**Beschreibung**

Wirbelschichtverfahren zur Produktion von Siliciumgranulat durch Feststoffabscheidung aus der Gasphase sind durch zahlreiche Veröffentlichungen und Patente bekannt.

Vereinfacht dargestellt, wird bei der Wirbelschichtabscheidung in einem Reaktor eine Schüttung aus Siliciumpartikel vorgelegt, diese Schüttung durch ein Gas fluidisiert und durch eine geeignete Vorrichtung auf die für die Abscheidereaktion notwendige Temperatur aufgeheizt. Eine im Gas enthaltene siliciumhaltige Verbindung, im Allgemeinen Silan $SiH_4$ oder Halogensilane $SiH_xX_y$ (Cl, Br, J, F), zersetzt sich an den heißen Partikeloberflächen in einer Pyrolysereaktion unter Bildung von elementarem Silicium, welches sich auf der Oberfläche der Siliciumpartikel in der fluidisierten Schüttung niederschlägt und zu einem Größenwachstum dieser Partikel führt.
Das Verfahren kann stationär kontinuierlich betrieben werden, wenn man laufend angewachsene Partikel als Produkt aus der Wirbelschicht abführt und Partikel geringerer Größe, so genannte Siliciumkeimpartikel, der Wirbelschicht wieder zuführt.

Im Allgemeinen wird der Wirbelschicht nicht nur die siliciumhaltige Verbindung zugeführt, sondern auch noch ein siliciumfreies Gas, das im Folgenden als Verdünnungsgas bezeichnet wird. Beispiele für dieses Verdünnungsgas sind Wasserstoff, Stickstoff oder Argon. Die Zufuhr der siliciumhaltigen Verbindung, alleine oder mit Verdünnungsgas gemischt, wird im Weiteren als Reaktionsgas bezeichnet.

Die Kernproblematik bei der Wirbelschichtabscheidung von Silicium ist die Tatsache, dass die siliciumhaltigen, gasförmigen Verbindungen nicht nur an den heißen Partikeloberflächen reagieren, sondern auch unerwünschterweise an heißen Reaktorbauteilen. Hiervon ist insbesondere die Bewandung der Wirbelschicht betroffen. Ohne besondere Maßnahmen scheidet sich auf dieser Wand eine Siliciumschicht ab, die mit der Laufzeit des Reaktors immer dicker wird und so die maximale Laufzeit des Reaktors begrenzt. Besonders schwerwiegend ist dieses Problem, weil man die Wirbelschicht im Allgemeinen über genau diese Wand beheizt und eine aufwachsende Siliciumschicht die Funktion der Heizung beeinträchtigt, da sie einen thermischen Isolator darstellt. Es können auch mechanische Spannungen aufgrund der unterschiedlichen Wärmedehnung von Wandmaterial und aufgewachsener Siliciumschicht zum Abplatzen von Teilen der Siliciumschicht oder sogar zum Bruch der Wirbelschichtbewandung führen. Neben der Abscheidung auf der Bewandung der Wirbelschicht ist ein weiteres Problem die Abscheidung von massivem Silicium auf den Reaktorbauteilen, die zum Einlass des Reaktionsgases, also des siliciumhaltigen Gases oder Gasgemisches, in die Wirbelschicht dienen. Hier kann die Wandabscheidung bis zum Verstopfen des Einlasses führen.

Ein elementarer Faktor bei der Wirbelschichtabscheidung ist der Nettoheizbedarf der Wirbelschicht, d.h. die Heizmenge, die dem Reaktor über die Reaktorwand zugeführt wird. Dieser beeinflusst sehr stark die Kosten des Verfahrens. Mit zunehmender Abscheidung an den Reaktorteilen steigt der Energiebedarf und im Extremfall ist der Reaktor nicht mehr zu beheizen und muss abgestellt werden. Der Nettoheizbedarf ergibt sich größtenteils aus der Differenz zwischen Wirbelschichttemperatur und Temperatur der zugeführten Gase. Die Reaktionsenthalpie der Gasphasenabscheidung ist dagegen von untergeordneter Bedeutung. Die Wirbelschichttemperatur entspricht der erforderlichen Reaktionstemperatur für die Pyrolysereaktion und hängt stark ab von der Art und Konzentration der siliciumhaltigen Verbindung.

Das Hauptmerkmal des Produktes der Wirbelschichtabscheidung ist die sehr hohe geforderte Reinheit. Im Allgemeinen sollte die Verunreinigung durch Metalle geringer als 100 ppbw sein, die Verunreinigung durch die Dotierstoffe Bor und Phosphor sollte geringer als 1000 pptw, die Verunreinigung durch Kohlenstoff geringer als 1000 ppbw sein.

In der Literatur sind unterschiedliche Ansätze genannt, die beschriebenen Probleme zu lösen:

US 3,963,838 beschreibt ein Verfahren, bei dem der Belag auf der Reaktorwand aus Quarz im Prozess laufend von der Quarzwand abplatzt. Nachteilig dabei ist hier, dass das Material der Wandabplatzung andere Charakteristika als sphärisches Granulat hat und beim Abplatzen die Gefahr des Quarzglasbruches besteht. Ebenfalls kann das Granulat durch die Wandabplatzung unerwünschtes Quarz enthalten.

JP 2279513 beschreibt einen Prozess mit einer einfach aufgebauten Wirbelschicht. Das Reaktionsgas strömt über eine Verteilerplatte am Boden der Wirbelschicht ein.
Die Wirbelschicht wird konventionell über die Wand beheizt. Um zu verhindern, dass der Gasverteilerboden durch Wandabscheidung verblockt, wird dem Reaktionsgas eine geringe Menge HCl zudosiert. Durch eine Reduktionsreaktion, wird so im Einströmbereich des Reaktionsgases Si zu Chlorsilanen reduziert und damit die Wandabscheidung in diesem Bereich reduziert bzw. verhindert. Nachteilig an diesem Verfahren ist jedoch, dass die Wandabscheidung im Bereich der Reaktorheizung nicht verhindert wird und hohe Wärmeverluste am Wirbelschichtboden entstehen. Weiterhin wird bei dieser Verfahrensweise Siliciumgranulat in der Reaktiongasatmosphäre abgezogen und muss dadurch zusätzlich gespült (inertisiert) werden.

Aus US 4,992,245 ist bekannt, die Heizung der Wirbelschicht nicht durch Wandabscheidung zu beeinträchtigen, indem die Wirbelschicht in eine innere Reaktionszone und eine diese ringförmig umschließende Heizzone geteilt wird. Die Teilung erfolgt dabei durch ein zylindrisches Rohr. Die Reaktionszone wird durch Reaktionsgas fluidisiert, die Heizzone wird mit Verdünnungsgas gespült. Das Granulat zirkuliert zwischen der Heizzone und der Reaktionszone und trägt so die Wärme von der Heizzone in den Reaktionsbereich. Nachteilig bei diesem Verfahren ist jedoch, dass die zirkulierende Wirbelschicht sehr komplex aufgebaut ist und aus inerten Werkstoffen (Quarz o.ä.) nur sehr schwierig herstellbar ist. Der Aufbau kann auch nicht verhindern, dass das Reaktionsgas in den Bereich der Heizzone gerät und dort zur Wandabscheidung führt, was wiederum die Reaktorheizung beeinträchtigt. Auch die Gasführung ist in dieser Verfahrensanordnung sehr aufwändig.

Einen anderen Weg beschreibt US 5,374,413. Um die Heizung der Wirbelschicht nicht durch Wandabscheidung zu beeinträchtigen, wird hier die Wirbelschicht vertikal oder horizontal in eine Reaktionszone und eine Heizzone geteilt. Die Teilung erfolgt durch eine Wand bzw. ein zylindrisches Rohr. Die Beheizung in der Heizzone erfolgt durch Mikrowelle, wobei die Wand des Reaktors aus Quarz und somit transparent für Mikrowellen ist. Nachteilig ist jedoch, dass die Wärme durch Partikel- und Gaskonvektion von der Heizzone zur Reaktionszone transportiert werden muss. Bei vertikaler Trennung (Reaktionszone oben - Heizzone unten) entsteht eine sehr hohe Wirbelschicht mit der Gefahr des Umschlags in den stoßenden Betrieb bzw. der Bildung von sehr großen Blasen im Reaktionsbereich. Eine Wandabscheidung auf den Bauteilen zur Trennung in die Zonen ist auch in diesem Verfahren zu erkennen. Ein großer Nachteil ist der geringe Wirkungsgrad der Mikrowellenheizung, der extrem von der Form und der Größe des Reaktors abhängig ist und somit industriell nur von geringem Nutzen ist.

DE 19948395 beschreibt die vertikale Trennung der Wirbelschicht in eine Heizzone und eine darüber liegende Reaktionszone. Die Trennung erfolgt durch die Zuführeinrichtung für das Reaktionsgas. Die Heizzone wird nur durch Verdünnungsgas fluidisiert. Die Heizung erfolgt durch einen Strahlungsheizer im Bereich der Heizzone, wobei die Wirbelschichtwand so ausgeführt ist, dass diese für die Wärmestrahlung weitgehend transparent ist. Abzug des Produktes erfolgt aus der Heizzone. Aufwändig ist bei dieser Prozessführung, dass die Wärme durch Partikel- und Gaskonvektion von der Heizzone zur Reaktionszone transportiert werden muss.

US 6,827,786 beschreibt ebenfalls eine vertikale Trennung der Wirbelschicht in eine Heizzone und eine darüber liegende Reaktionszone. Die Trennung erfolgt dadurch, dass am Boden der Wirbelschicht nur Verdünnungsgas einströmt und das Reaktionsgas erst weiter oben durch radial angeordnete Düsen einströmt. Die Beheizung erfolgt über Wandheizung im unteren Bereich (Heizzone). Auch im Reaktionsbereich kann durch Wandheizung geheizt werden. Die Abgrenzung zu DE 19948395A1 und US 5,374,413 erfolgt dadurch, dass das Verdünnungsgas pulsierend der Heizzone zugeführt wird und durch diese Pulsation der Wärmetransport von der Heizzone in die Reaktionszone verbessert wird. Oberhalb der Reaktionszone kann noch eine weitere beheizte Reaktionszone zur Konvertierung von Tetrachlorsilan angeordnet sein. Nachteilig ist auch hier, dass die Wärme durch Partikel- und Gaskonvektion (Pulsation) von der Heizzone zur Reaktionszone transportiert werden muss und weiterhin Wandabscheidung in der Reaktionszone, insbesondere durch die wandnahe (radiale) Reaktionsgaszufuhr, stattfinden kann.

EP-A-0 896 952 beschreibt ein Verfahren zur Herstellung von hochreinem Polysiliciumgranulat durch Abscheidung eines Reaktionsgases an Siliciumgranulat in einem Wirbelschichtreaktor, umfassend:

- Einen Reaktor mit einem Reaktorraum bestehend aus mindestens zwei hintereinander liegenden Zonen.
- Eine Heizzone, in der eine Fraktion der Siliciumpartikel mittels eines inerten, siliciumfreien Trägergases fluidisiert und erhitzt wird.
- Daran angeschlossen eine weitere Zone, die in direktem Kontakt mit der ersten Zone steht.

In diese dort gebildete Reaktionszone wird ein siliciumhaltiges Reaktionsgas durch eine oder mehrere röhrenförmige Düsen direkt in die Reaktionszone eingebracht, wobei durch thermische Expansion große Gasblasen generiert werden, die zu heterogenen Wirbelschichten innerhalb der Reaktionszone führen, innerhalb derer sich das siliciumhaltige Gas an den Partikeloberflächen zersetzt und zum Partikelwachstum führt.

NTIS TECH NOTES, US Department of Commerce. Springfield, VA, US, 1. März 1992 (1992-03-01), Seite 209 oder WO 2004/013044 A beschreiben ein ähnliches Verfahren, dadurch gekennzeichnet, dass die Siliciumpartikel nicht in der unteren Zone (Fluidisierzone) erhitzt werden, sondern in der oberen Zone, die Reaktionszone.

Alle im Stand der Technik genannten Verfahren haben den Nachteil, dass an verschiedenen Bauteilen der Reaktoren eine Wandabscheidung von Silicium stattfindet und mit zunehmender Betriebszeit die Heizleistung durch Isolation sinkt oder verfahrensnotwendige Bauteile durch die Abscheidung verstopfen. Diese Effekte sind mit erhöhten Energiekosten, negativen Sicherheitsaspekten (Verstopfen der Anlage) und Ausfallzeiten der Anlage durch Stillstand und mechanischer Entfernung der abgeschiedenen Schicht verbunden.

Es bestand daher die Aufgabe, ein Verfahren zur kontinuierlichen Herstellung von hochreinem, homogenpolykristallinem Siliciumgranulat bereitzustellen, bei dem die Wandabscheidung stark reduziert, beziehungsweise ganz unterdrückt wird, so dass eine effiziente Beheizung der Wirbelschicht und eine lange Laufzeit des Reaktors ermöglicht wird. Dabei soll der entsprechende Apparat einen möglichst einfachen Aufbau vorweisen, der den begrenzten Konstruktionsmöglichkeiten gerecht wird und der Heizbedarf der Wirbelschicht möglichst minimiert wird.

Gleichzeitig bestand die Aufgabe, durch geeignete Wahl der Reaktionsführung, die Bildung und den Austrag von Siliciumstaub aus der Wirbelschicht soweit zu reduzieren, dass zusätzliche Maßnahmen entfallen können. Das erhaltene Produkt soll dabei ohne zusätzliche Behandlungsschritte in hoher Reinheit, in der gewünschten Korngrößenverteilung, poren- und staubfrei anfallen.

Gegenstand der Erfindung ist ein Verfahren zur Herstellung von hochreinem Polysiliciumgranulat durch Abscheidung eines Reaktionsgases an Siliciumgranulat in einem Wirbelschichtreaktor, umfassend:

(I) einen Reaktor mit einem Reaktorraum bestehend aus mindestens zwei hintereinander liegenden Zonen,

(II) wobei die untere Zone, die eine Höhe von 50 bis 300 mm aufweist, durch die Einleitung eines Silicium-freien Gases mittels Einzeldüsen bei einer Austrittgeschwindigkeit von 20 bis 200 m/s in das Siliciumgranulat schwach fluidisiert wird, wobei die Gasgeschwindigkeit in der unteren Zone das 1,2 bis 2,3-fache der Lockerungsgasgeschwindigkeit beträgt;

(III)wobei daran in direktem Kontakt eine weitere Zone angeschlossen ist, die in direktem Kontakt mit der ersten Zone steht

(IV) diese Zone über deren nach außen begrenzende Wandung beheizt wird, und

(V) in die dort gebildete Reaktionszone ein siliciumhaltiges Reaktionsgas mittels einer oder mehrerer Düsen mit einer Geschwindigkeit von 1 bis 140 m/s als vertikal nach oben gerichteter Gasstrahl eingedüst wird, wobei sich oberhalb der Düsen lokale Reaktionsgasstrahlen umgeben von blasenbildender Wirbelschicht bilden, innerhalb derer sich das siliciumhaltige Gas an den Partikeloberflächen zersetzt und zum Partikelwachstum führt, und

(VI) das Reaktionsgas dabei in der Art eingeleitet wird, dass es nahezu bis zum chemischen Gleichgewichtsumsatz abreagiert ist, bevor es entweder die Wirbelschichtbewandung oder die Wirbelschichtoberfläche erreicht.

Im erfindungsgemäßen Verfahren wird durch geeignete Wahl der Verfahrensparameter der mittleren Gasgeschwindigkeit in den beiden fluidisierten Zonen der Wirbelschicht, der lokalen Gasgeschwindigkeiten der Gase bzw. Gasgemische am Austritt der Düsensysteme, des Drucks und der Temperatur der Wirbelschicht, der Platzierung der Düsen relativ zueinander und relativ zur Wirbelschichtbewandung und der Verweilzeit der Gase in den fluidisierten Zonen der Wirbelschicht ein Reaktionsverlauf und damit ein Konzentrationsprofil erzeugt, welches gewährleistet, dass das Reaktionsgas nahezu bis zum chemischen Gleichgewichtsumsatz abreagiert ist, bevor es entweder die Wirbelschichtbewandung oder die Wirbelschichtoberfläche erreicht. Dadurch wird Wandabscheidung an der Wirbelschichtbewandung auf ein sehr geringes Maß reduziert, was die unbeeinträchtigte Beheizung der Wirbelschicht im Bereich der Reaktionszone über einen langen Zeitraum ermöglicht.

Das Reaktionsgas wird dabei erfindungsgemäß als ein oder mehrere vertikal nach oben gerichtete Gasstrahlen in die mittels Verdünnungsgas schwach fluidisierte Wirbelschicht eingedüst und zwar in einer Art und Weise, dass sich oberhalb der Zuführdüsen innerhalb der Wirbelschicht eine oder mehrere lokale Reaktionsbereiche ausbilden, in denen das Reaktionsgas nahezu vollständig bis zum chemischen Gleichgewicht reagiert, bevor es die Wirbelschichtbewandung oder die Wirbelschichtoberfläche erreicht. Dies ermöglicht es, die Wirbelschicht auf Höhe des Reaktionsbereiches herkömmlich über die Wand dauerhaft zu beheizen, ohne eine Wandabscheidung zu erhalten.

Die Ausbildung der Wirbelschicht in zwei Zonen wird dadurch erreicht, dass die untere Zone nur mittels Verdünnungsgas fluidisiert wird und das Reaktionsgas erst auf höherem Niveau in die Wirbelschicht eingedüst wird. Im Bereich unterhalb des Niveaus der Reaktionsgaseindüsung wird die Wirbelschicht mittels Verdünnungsgas nur schwach fluidisiert. Verzichtet man auf diese Grundfluidisierung, bildet sich durch die Reaktionsgasdüsen eine reine Strahlwirbelschicht, die für den angestrebten Prozess nicht zielführend ist.

Die Höhe der unteren Zone ist so auszulegen, dass kein Reaktionsgas bis zu den Düsen für das Verdünnungsgas zur Fluidisierung der unteren Zone zurückströmen und diese durch Wandabscheidung verblocken kann und liegt im Bereich von 50 bis 300 mm.

Die Höhe der unteren Zone im erfindungsgemäßen Verfahren ist im Gegensatz zu den bekannten Verfahren aus US 5,374,413, DE 19948395 und US 6,827,786 für die Beheizung der Wirbelschicht unerheblich und muss auch nicht hinsichtlich der Heizung ausgelegt werden. Es hat sich gezeigt, dass diese Zone sehr flach ausgeführt werden kann. Bereits eine Höhe größer 50 mm reicht aus. Eine zusätzliche Beheizung diese Zone ist jedoch grundsätzlich machbar und kann die Gesamtwärmezufuhr in die Wirbelschicht erhöhen bzw. Wärmeverluste in diesem Bereich ausgleichen.

Die Menge an Verdünnungsgas, das der unteren Zone zugeführt wird, ist so gering zu wählen, dass die Wirbelschicht gerade, aber noch sicher, fluidisiert wird. Bevorzugt wird das Verdünnungsgas in einer Menge zugeführt, dass die Gasgeschwindigkeit in der unteren Zone das 1,2 bis 2,3 -fache, bevorzugt das 1,2 bis 1,7 -fache der Lockerungsgasgeschwindigkeit beträgt.

Die Lockerungsgasgeschwindigkeit ist abhängig von Korngröße sowie Stoffdaten von Feststoff und Gas und kann z.B. berechnet werden nach Gleichung (18) Chapter 3 in "Fluidization Engineering"; D. Kunii, O. Levenspiel; Butterwoth-Heinemann; Second Edition 1991:

$$\frac{1.75}{\varepsilon_{mf}^3 \phi_s}\left(\frac{d_p u_{mf}\rho_g}{\mu}\right)^2 + \frac{150(1-\varepsilon_{mf})}{\varepsilon_{mf}^3 \phi_s^2}\left(\frac{d_p u_{mf}\rho_g}{\mu}\right) = \frac{d_p^3 \rho_g \left(\rho_s - \rho_g\right)g}{\mu^2}$$

mit

| | |
|---|---|
| $\varepsilon_{mf}$ | Hohlraumanteil am Loc ker ungspunkt |
| $\phi_s$ | Sphärizität der Partikel |
| $d_p$ | Partikeldurchmesser |
| $\rho_g$ | Gasdichte |
| $\rho_s$ | Feststoffdichte |
| $\mu$ | dynamische Viskosität des Gases |
| g | Erdbeschleunigung |

Geringere Gasdurchsätze führen in der oberen Zone zu einer unerwünschten Strahlwirbelschicht, größere Durchsätze erhöhen den Gas- und Energieverbrauch und haben negative Auswirkungen auf die Ausbildung der Reaktionszone. Dort führt ein Überschuss an Verdünnungsgas zur Bildung von größeren Blasen, die an der Reaktionsgaseindüsung lokal zu Rückströmungen und Wandabscheidung auf der Düse bzw. zu Bildung von amorphem Staub führen können.

Das Verdünnungsgas, das separat der unteren Zone zugeführt wird, kann bis über die Wirbelschichttemperatur geheizt werden und transportiert dann zusätzlich Wärme in die Wirbelschicht. In der praktischen Anwendung hat sich gezeigt, dass in bevorzugter Weise dieses Gas in einem konventionellen Wärmetauscher mit metallischen Heizelementen auf Temperaturen von mindestens 500°C, besonders bevorzugt von mindestens 700°C, vorgeheizt wird, ohne dass es zu einer nachweisbaren Kontamination des Produktes kommt.

Bevorzugt wird das Verdünnungsgas über mehrere, möglichst gleichmäßig über den Querschnitt der Wirbelschicht verteilte Einzeldüsen zugeführt. Dadurch wird in diesem schwach fluidisierten Bereich ein hohes Maß an Turbulenz erzeugt, wodurch effektiv die Bildung von Agglomeraten verhindert werden kann. Dies ist insbesondere deshalb wichtig, weil aus diesem Bereich auch das abgeschiedene Produktgranulat aus der Wirbelschicht abgezogen wird. Die Austrittsgeschwindigkeit des Verdünnungsgases aus den Düsen muss dabei so gewählt werden, dass jeweils ein lokaler Strahlbereich entsteht. Die maximalen Jetgeschwindigkeiten liegen im Bereich 20 bis 200 m/s, bevorzugt im Bereich 50 bis 180 m/s und ganz besonders bevorzugt im Bereich 75 bis 170 m/s. Wird die Geschwindigkeit zu klein gewählt, so kann Granulat in die Düsen gelangen und diese verblocken bzw. bringt der Düsenstrahl zu geringe Turbulenz in die untere Zone, so dass Agglomerate nicht zuverlässig aufgebrochen werden bzw. deren Bildung nicht verhindert wird. Wird die Geschwindigkeit zu groß gewählt, führt der Gasstrahl zu einer mechanischen Zerkleinerung des Siliciumgranulates bzw. zu sehr hohen Raten an Feststoffabrieb.

Als Reaktionsgas kommen siliciumhaltige Gase (z.B. $SiH_4$, $SiCl_4$, $SiHCl_3$, $SiH_xCl_y$) oder Mischungen dieser Gase mit einem siliciumfreien Gas, wie z.B. Wasserstoff, Stickstoff oder Argon, als Verdünnungsgas zum Einsatz. Bevorzugt wird als Reaktionsgas Trichlorsilan ($SiHCl_3$) verdünnt mit Wasserstoff ($H_2$) verwendet.

Der Molanteil an Trichlorsilan im Reaktionsgas liegt im Bereich von 0,2 bis 0,8 und ganz besonders bevorzugt im Bereich 0,3 bis 0,6. Hierbei ist auch ein eventuell zugemischtes Verdünnungsgas aus einer, die Reaktionsgasdüse umgebende Ringspaltdüse mit berücksichtigt. Zusammen mit dem Verdünnungsgas aus der unteren Zone liegt der mittlere Molanteil über den gesamten Reaktorquerschnitt bevorzugt im Bereich 0,15 bis 0,4.

Vorteilhaft werden die Gase vor Eintritt in die Wirbelschicht vorgeheizt, um damit den Heizbedarf für die Wirbelschicht gering zu halten. Allerdings ist eine solche Vorheizung begrenzt. Beim Reaktionsgas begrenzt die jeweilige Zersetzungstemperatur der siliciumhaltigen Verbindungen die Vorwärmung. In überraschender Weise hat sich in den Versuchen gezeigt, dass das Reaktionsgas mittels konventioneller Heiztechnologie deutlich über die bislang in der Literatur angegebenen Temperaturen vorgeheizt werden kann (Zersetzungstemperatur von Trichlorsilan = 350°C: "Machine For Production Of Granular Silicon"; Lord; 2004; US 6,827,786), ohne dass es zu einer Zersetzung vor Eintritt in die Wirbelschicht kommt und so der Heizbedarf der Wirbelschicht reduziert werden kann.

Die Vorheizung des Reaktionsgases kann z.B. über einen konventionellen Wärmetauscher mit metallischen Heizelementen erfolgen. Bevorzugt wird dabei das Gasgemisch (Trichlorsilan und Wasserstoff) auf 350°C bis 590°C vorgeheizt.

Die Austrittsgeschwindigkeit des Reaktionsgases aus den Reaktionsgasdüsen muss so gewählt werden, dass dabei ein Strahlbereich entsteht. Die lokalen Gasgeschwindigkeiten der Gase bzw. Gasgemische am Austritt der Düsensysteme liegen im Bereich 1 bis 140 m/s, bevorzugt im Bereich 10 bis 120 m/s und ganz besonders bevorzugt im Bereich 40 bis 70 m/s. Eine Einstellung der Jetgeschwindigkeit kann durch die Auswahl einer geeigneten Düsenquerschnittsfläche eingestellt werden. Wird die Geschwindigkeit zu klein gewählt, so bildet sich kein lokal begrenzter Strahlbereich aus, sondern das Reaktionsgas strömt aus der Düse als einzelne Blasen in die Wirbelschicht ab, verteilt sich in unerwünschter Weise sofort über den ganzen Querschnitt und kann dann zur unerwünschten Wandabscheidung führen. Außerdem kann Granulat in die Reaktionsgasdüse gelangen und diese verblocken. Wird die Geschwindigkeit zu groß gewählt, führt der Gasstrahl zu einer mechanischen Zerkleinerung des Siliciumgranulates bzw. zu sehr hohen Raten an Feststoffabrieb und damit zur Erzeugung von unerwünschtem Siliciumstaub.

In der Reaktionszone liegt die mittlere Gasgeschwindigkeit im Bereich der 2 bis 8fachen, bevorzugt im Bereich der 3 bis 6fachen Lockerungsgasgeschwindigkeit.

Der Durchsatz an Reaktionsgas pro Düse ist begrenzt. Da das Reaktionsgas, limitiert durch die thermische Zersetzung der siliciumhaltigen Verbindung, deutlich kälter als die Wirbelschichttemperatur (= erforderliche Reaktionstemperatur für die heterogene Pyrolyse) zuströmt, kommt es im Strahlbereich zu einer lokalen Unterkühlung der Wirbelschicht. Die Unterkühlung in diesem Bereich und auch die Größe dieses Bereichs werden mit zunehmendem Düsendurchsatz größer. Wird dieser Bereich zu kalt bzw. zu groß, so verschiebt sich die Reaktionsselektivität weg von der erwünschten heterogenen hin zur unerwünschten homogenen Gasphasenreaktion unter Bildung von amorphem Siliciumstaub. Der aus Experimenten abgeleitete Grenzwert für den maximalen Düsendurchsatz lässt sich am besten charakterisieren als maximale Wärmesenke, berechnet aus Gasdurchsatz pro Düse, Wärmekapazität des Reaktionsgases und Temperaturdifferenz zwischen zuströmendem Reaktionsgas und vorliegender Wirbelschichttemperatur und liegt im Bereich von 5 bis 25 kW pro Düse:

$$\dot{Q}_{Senke} = \dot{m}_{RG} * c_{PRG} * (T_{WS} - T_{RG})$$

mit

$$\dot{Q}_{Senke} \quad W\ddot{a}rmesenke \quad [W]$$

$$\dot{m}_{RG} \quad Massenstrom \quad Re\,aktionsgas \quad \left[\frac{kg}{s}\right]$$

$$c_{PRG} \quad W\ddot{a}rmekapazit\ddot{a}t \quad Re\,aktiosnggas \quad \left[\frac{kJ}{kg\,K}\right]$$

$$T_{WS} \quad Temperatur \quad Wirbelschicht \quad [K]$$

$$T_{RG} \quad Temperatur \quad Re\,aktionsgas \quad [K]$$

Die Abstände der Düsen von der Wirbelschichtbewandung sind so zu wählen, dass das Reaktionsgas möglichst vollständig bis zum chemischen Gleichgewicht abreagiert, bevor es die Wirbelschichtbewandung erreicht. Aus Versuchen wurde quasi äquivalent zum Strahlwinkel der Jetströmung, ein Winkel für die "Reaktionsfront" ermittelt. Dieser Winkel liegt im Bereich von 9,5° bis 18°. In Kombination mit der mindestens erforderlichen Verweilzeit bzw. Höhe der Reaktionszone lässt sich der mindestens erforderliche Wandabstand der Düse an Hand der Formel (B) ermitteln.

$$A_{W-D} \geq h_{RZ} * \tan\alpha$$

mit

$A_{W-D}$ Abstand Wand-Düse [m]

α Winkel Reaktionsfront

Die einzelnen Düsen dürfen auch untereinander nicht zu nahe aneinander stehen, sonst besteht die Gefahr, dass die Einzelstrahlen zusammenwachsen und quasi einen Strahl bilden, wobei dann unter Umständen die Grenze für die Wärmelast überschritten wird. Der Mindestabstand ist so zu wählen, dass das Verhältnis aus Düsenabstand (horizontaler Abstand zwischen den Strahlachsen) zu Düsendurchmesser (Innendurchmesser der Düse am Ort des Gasaustrittes in die Wirbelschicht) größer als 7,5, ganz besonders bevorzugt größer als 8,5 ist.

Neben der Abscheidung auf der Bewandung der Wirbelschicht ist ein weiteres Problem die Abscheidung von Silicium auf den Reaktorbauteilen, die zum Einlass des Reaktionsgases in die Wirbelschicht dienen. Diese Abscheidung an den Düsen kann bis zum Verstopfen des Einlasses führen.

Zur Vermeidung der Abscheidung auf den Düsen können diese entweder, wie aus dem Stand der Technik bekannt, gekühlt werden (US 5,810,934, US 6,827,786) oder die Abscheidung wird durch den Zusatz von geringen Mengen an Chlorwasserstoffgas zum Reaktionsgas vermieden (JP 2279513), wobei zusätzlich die Bildung von Feinstaub durch homogene Gasphasenreaktion vermindert wird. Aus US 5,798,137 (S. 30, Z. 26 - 49; S. 28, Z. 44 - 47) ist auch die Verwendung von Ringdüsensystemen bekannt, wobei durch eine innere Düse das Reaktionsgas zugeführt wird und durch eine diese Düse umschließende Ringdüse ein Ringspalt gebildet wird, durch den ein Halogengas oder eine Mischung aus Verdünnungsgas und einem Halogengas geleitet wird, um Abscheidung auf Bauteilen im Bereich des Gaseinlasses zu vermeiden.

Vorteilhaft wird die Kühlung und der Schutz vor Abscheidung mittels eines Ringdüsensystems erreicht, wobei durch die zentrale Düse das Reaktionsgas geleitet wird, durch die Ringdüse nur Verdünnungsgas. Damit das Verdünnungsgas aus der Ringdüse neben der Kühlung auch einen Abschirmeffekt erwirkt, ist die Austrittsgeschwindigkeit an der Ringdüse überraschend zwingend kleiner zu wählen als die Austrittsgeschwindigkeit an der zentralen Düse. Die Geschwindigkeit an der Ringdüse wird dabei bevorzugt im Bereich $0,4*V_{Zentraldüse} < V_{Ringdüse} < 0,8* V_{Zentraldüse}$ gewählt. Ansonsten gelten die weiter oben genannten Geschwindigkeits- und Durchsatzgrenzen. Ist der Gasstrahl aus der Ringdüse zu langsam, entfällt die Schutzwirkung für die zentrale Düse, ist der Gasstrahl aus der Ringdüse schneller als der zentrale Strahl, so führt dies dazu, dass der zentrale Gasstrahl aufgeweitet wird mit negativen Folgen für die Ausbildung der Reaktionszone.

Die Menge an Verdünnungsgas durch den Ringspalt muss dabei so groß gewählt werden, dass die zentrale Düse sicher vor Wandabscheidung geschützt wird.

Durch die schwache Fluidisierung im unteren Bereich und der Strahlcharakteristik strömt im Bereich der Düsen kein Reaktionsgas unter das Niveau der Düsenöffnung und Wandabscheidung wird dort sicher vermieden.

Die Höhe der Wirbelschicht über dem Niveau des Reaktionsgasaustrittes wird so groß gewählt, dass das Reaktionsgas möglichst größer 90 % bis zum chemischen Gleichgewicht abreagiert, bevor es die Wirbelschichtoberfläche erreicht. Am besten wird dies charakterisiert, durch die gemittelte Verweilzeit des Reaktionsgases in der Wirbelschicht anhand der folgenden Formel (A):

$$\bar{t} = \frac{U_{RZ}}{\varepsilon * h_{RZ}}$$

mit

t mittlere Verweilzeit [s]

$U_{RZ}$ Leerrohrgasgeschwindigkeit in der Reaktionszone $\left[\dfrac{m}{s}\right]$

ε Porosität Wirbelschicht

$h_{RZ}$ Höhe Reaktionszone [m]

Die Verweilzeit der Gase in der oberen Zone der Wirbelschicht liegt im Bereich 0,1 bis 10 Sekunden, bevorzugt 0,1 bis 3 Sekunden und ganz besonders bevorzugt 0,2 bis 2 Sekunden. Bei zu kurzen Verweilzeiten ist das Reaktionsgas noch nicht vollständig abreagiert und kann sich im Abströmbereich der Wirbelschicht noch in Form von Wandabscheidung oder durch homogene Gasphasenreaktion zu Staub umsetzen. Zu große Verweilzeiten dagegen führen zu unnötig hohen Wirbelschichten mit entsprechend ungünstigem Verhalten.

Durch das erfindungsgemäße Verfahren kann in unmittelbarer Nähe zum Reaktionsgebiet die Wirbelschicht konventionell und damit kostengünstig beheizt werden, ohne dass über einen langen Zeitraum mit einer Beeinträchtigung der Heizung durch Wandabscheidung zu rechnen ist. Im Allgemeinen reicht die Höhe der Reaktionszone aus, um die Wirbelschicht über die Wand in dieser Zone zu beheizen. Sehr spezielle und aufwändige Heizarten (Mikrowelle, Laser), komplexe Reaktoranordnungen oder Betriebsarten (vertikale Trennung von Heizung und Reaktion, pulsierende Gaszufuhr, Umlaufsysteme) entfallen. In den Experimenten hat sich überraschender Weise gezeigt, dass eine Heizeranordnung, wie in US 7,029,632 beschrieben, besonders gut geeignet ist.

Die mindestens erforderliche Wirbelschichttemperatur steigt, ausgehend von Silan, mit steigendem Chlorgehalt der eingesetzten siliciumhaltigen Verbindung stark an. Die für den Prozess erforderliche Betttemperatur der Wirbelschicht liegt im Bereich 890 bis 1400°C, in der bevorzugten Ausführung (Einsatz Trichlorsilan) im Bereich 890 bis 1100°C und ganz besonders bevorzugt im Bereich 930 bis 1000°C.

Hinsichtlich des Reaktordrucks ist eine Fahrweise im Bereich von 0 bis 7 bar Überdruck, bevorzugt im Bereich 0,3 bis 4 und ganz besonders bevorzugt im Bereich von 0,5 bis 3 bar Überdruck möglich.

In Experimenten wurde das beschriebene Verfahren mit verschiedenen Korngrößenverteilungen in der Wirbelschicht betrieben und untersucht. Überraschenderweise hat sich gezeigt, dass der Reaktionsumsatz und damit die Abscheiderate nicht mit dem mittleren Partikeldurchmesser sondern nur mit dem Sauterdurchmesser $d_{32}$ korreliert. Als besonders vorteilhaft hat sich der Betrieb der Wirbelschicht mit einer stationären Korngrößenverteilung erwiesen, dadurch gekennzeichnet, dass die Partikel zwischen 150 und 7000 $\mu$m groß sind und der Sauterdurchmesser der Verteilung im Bereich 850 bis 1500 besonders bevorzugt im Bereich 950 bis 1400 $\mu$m liegt.

Im Stand der Technik (US 5,798,137, S. 6, Z. 57 - 65) ist die Steuerung einer stabilen und stationären Korngrößenverteilung in der Wirbelschicht als sehr schwierig eingestuft. In den Experimenten mit dem erfindungsgemäßen Verfahren hat sich aber gezeigt, dass unter Verwendungen einer Online-Abgasanalytik zur Bestimmung des Reaktionsumsatzes in Kombination mit einer Erfassung der Mengen an zugeführtem Reaktions- und Verdünnungsgas und einem Rechenmodell zur Partikelpopulation die Zugabe der Keimpartikel und der Produktabzug so gesteuert werden kann, dass die gewünschte Korngrößenverteilung im Reaktor und die Menge an Granulat in der Wirbelschicht über einen langen Zeitraum hinweg stabil und stationär gehalten werden kann. Voraussetzung hierfür ist wiederum eine stabile und gleichbleibende Korngrößenverteilung der Keimpartikel. Dabei kann die Zugabe der Keimpartikel sowohl kontinuierlich als auch zyklisch erfolgen.

Durch die erfindungsgemäße Prozessführung und unter Verwendung von Trichlorsilan wird die Bildung von Staub durch Abrieb und homogener Gasphasenabscheidung auf ein Minimum reduziert, insbesondere polymere Siliciumverbindungen im Abgas, auch als "Hochsieder" bezeichnet, treten nicht auf. Somit können zusätzliche Maßnahmen entfallen und das erhaltene Siliciumgranulat wird ohne zusätzliche Behandlungsschritte in hoher Reinheit, höchster Dichte in der gewünschten Korngrößenverteilung, porenfrei, mit sehr geringem Staubgehalt und mit einem niedrigen Gehalt an Chlor erhalten.

Durch den Abzug von Produktgranulat aus der schwach fluidisierten und nur von Verdünnungsgas durchströmten unteren Zone der Wirbelschicht entfällt die Gefahr des Zuwachsens der Abzugsvorrichtung durch Wandabscheidung, das abgezogene Produktgranulat kann effektiv gekühlt und mit geringem Aufwand inertisiert werden. Dies ist beispielsweise sehr einfach durch Spülung mit Stickstoff in einem separaten Sammelbehälter möglich. Eine aufwändige Spülvorrichtung zur Abtrennung von Reaktionsgas oder gasförmigen Reaktionsprodukten ist somit nicht nötig, da siliciumhaltige Gase unter den gegebenen Prozessbedingungen nur sehr unwahrscheinlich in den Produktabzug gelangen können.

In überraschender Weise hat sich gezeigt, dass die beschriebene Anordnung (Zonen) zu einer Partikelsegregation führt, wodurch kleinere Partikel bevorzugt in der oberen Zone verbleiben und große Partikel bevorzugt in die untere Zone gelangen und von dort abgezogen werden können. Dadurch erhält man ein Produkt, das einen geringen Anteil an kleinen Partikeln enthält, so dass zusätzliche Arbeitsschritte zum Klassieren und Abtrennen eines Feinanteils entfallen können. Der Untergrößenanteil an Partikel kleiner 150 $\mu$m liegt beim erfindungsgemäßen Verfahren bei unter 0,1 Massenprozent, ohne dass ein zusätzlicher Klassierungsschritt notwendig ist.

Dadurch, dass eine separate Heizzone nicht erforderlich ist, kann die Höhe der Wirbelschicht im Vergleich zum Stand der Technik bei gleicher Verweilzeit des Reaktionsgases und Umsatz von Trichlorsilan soweit verringert werden, dass ein stabiler Betriebszustand der Wirbelschicht ohne Stoßen und damit ohne Abrieb und Bruch der Siliciumpartikel erreicht werden kann. Das so abgeschiedene Polysiliciumgranulat besitzt daher eine ausgesprochen kugelige Form mit Sphärizitätswerten im Bereich von 0,85 bis 1 [-], besonders bevorzugt im Bereich von 0,9 bis 0,99 [-]. Aus der Rundheit der Partikel ergeben sich die ausgesprochen guten Fließeigenschaften (Rieselfähigkeit) und entscheidende Vorteile in der Weiterverarbeitung in der Solar- und Halbleiterindustrie.

Ein weiterer Vorteil des in diesem Verfahren hergestellten Siliciumgranulates liegt in der poren- und partikeleinschlussfreien Abscheidung. So besitzt das Produkt in der Weiterverarbeitung große Vorteile durch höhere Abriebsbeständigkeit, geringe Ausgasung beim Aufschmelzen und hohe Schüttdichten.

Im Gegensatz zum konventionellen Verfahren ("Siemens-Prozess") ist das Granulat in der Wirbelschicht, die Siliciumkeimpartikel in den Zufuhrsystemen und das Produkt in den Abzugssystemen einem laufenden Wandkontakt ausgesetzt. Um hierbei eine Verunreinigung des Produktes zu vermeiden, ist die Auswahl an möglichen Konstruktionswerkstoffen, insbesondere für Bereiche, die sehr hohen Temperaturen ausgesetzt sind, sehr begrenzt. Bevorzugt wird der Reaktionsraum (Wirbelschichtbewandung, Düsen für Verdünnungsgas und Reaktionsgas, Produktabzug) aus hochreinem Quarz gefertigt. Alternativ können Werkstoffe wie Graphit, kohlefaserverstärktes Graphit, Siliciumkarbid oder kohlefaserverstärktes Siliciumkarbid mit Silicium beschichtet werden, um eine Kontamination des Produktes insbesondere mit Kohlenstoff oder mit Siliciumkarbidpartikeln zu vermeiden. Aufgrund der speziellen Eigenschaften aller dieser Werkstoffe sind die Konstruktionsmöglichkeiten stark eingeschränkt, weshalb der einfache Aufbau des Wirbelschichtabscheiders zum erfindungsgemäßen Verfahren von besonderem Vorteil ist.

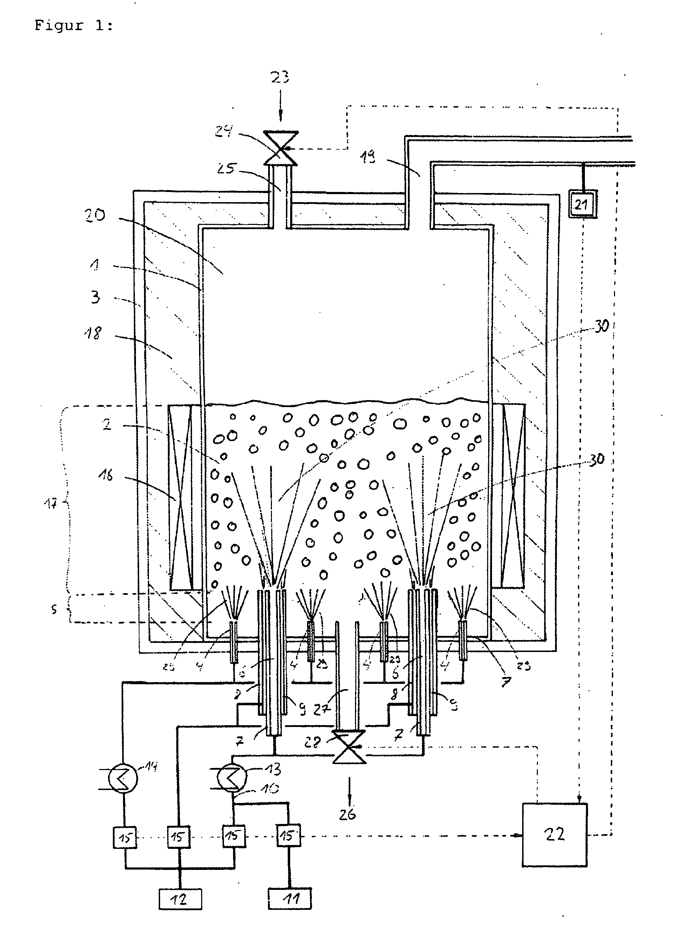

In Figur 1 ist eine apparative Ausführung zur Durchführung des Prozesses dargestellt:

Der Reaktionsraum wird durch ein Reaktionsrohr (1) gebildet, in welchem sich die Wirbelschicht (2) befindet und durch das Reaktionsgas und Verdünnungsgas geleitet werden. Das Reaktionsrohr ist von einem drucktragenden Gefäß (3) umschlossen und besteht aus einem möglichst reinen Werkstoff, der das Siliciumgranulat möglichst gering kontaminiert, bevorzugt aus hochreinem Quarz. Das Rohr kann zylindrisch mit konstantem Durchmesser oder aber mit nach oben größer werdendem Durchmesser ausgeführt werden. Das Verdünnungsgas wird über Einzeldüsen (4) in die untere Zone (5) der Wirbelschicht geführt, wobei sich an jeder Düse ein lokaler Strahlbereich (29) bildet. Diese Einzelstrahlen lösen sich nach oben hin zu einer blasenbildenden Wirbelschicht (2) auf.

Das Reaktionsgas wird über eine oder mehrere Reaktionsgaszuführungen (6) durch den Reaktorboden (37) in den Reaktor geführt und strömt in definierter Höhe über dem Niveau der Verdünnungsgasdüsen (4) in die Wirbelschicht. Dadurch bildet sich zwischen dem Gasaustritt des Reaktionsgases und dem Gasaustritt aus den Verdünnungsgasdüsen ein Wirbelschichtbereich (5), der nur von Verdünnungsgas durchströmt wird. Auch die Verdünnungsgasdüsen (4) und die Reaktionsgaszuführungen (6) sind aus einem möglichst reinen Werkstoff gefertigt, der das Siliciumgranulat möglichst gering kontaminiert, bevorzugt ebenfalls aus hochreinem Quarz.

Die Reaktionsgaszuführungen bestehen jeweils aus einer zentralen Reaktionsgasdüse (7) und einer, diese umschließenden, Ringdüse (8), so dass sich ein Ringspalt (9) für die Zuführung von Verdünnungsgas bildet.

Das Reaktionsgas (10) wird aus siliciumhaltigen Gas (11) und Verdünnungsgas (12) gemischt und über einen Wärmetauscher (13) vorgeheizt. Das Verdünnungsgas zum Ringspalt wird gesondert zugeführt, das Verdünnungsgas zur Fluidisierung der unteren Zone wird über einen Wärmetauscher (14) vorgeheizt. Alle Gasmengen werden über Mess- und Regelgeräte (15) erfasst und geregelt.

Durch die Anordnung bildet sich, ausgehend von den Reaktionsgaszuführungen (6) jeweils ein Strahlbereich (30) innerhalb einer blasenbildenden Wirbelschicht (2).

Außerhalb des Reaktionsrohres (1) ist eine geeignete Heizvorrichtung (16) angeordnet, mit der die Wirbelschicht auf der gesamten Höhe der oberen Zone (17) beheizt werden kann. Zur Reduzierung von Wärmeverlusten sind das Reaktorrohr (1) oberhalb und unterhalb der Heizvorrichtung sowie die Heizvorrichtung selbst von einer thermischen Isolation (18) umgeben. Die thermische Isolation (18) des Reaktionsrohres (1) oberhalb der Wirbelschicht kann in ihrer Ausführung (Art/Dicke/Form/Werkstoff) so angepasst werden, dass Wärmeverluste durch Abstrahlung von der Bettoberfläche minimiert werden, und gleichzeitig die Rohrwand möglichst nah an der Bettoberfläche schon auf Temperaturen unterhalb der Zersetzungstemperatur abkühlt, so dass auch ein nicht vollständig abreagiertes Gasgemisch nicht zu einer Wandabscheidung führt. Die aus der Wirbelschicht abströmenden Gase werden durch eine Abgasöffnung (19) aus dem Gasraum (20) des Reaktors abgeführt. Aus dem Abgasstrom wird ein Teilstrom über ein Analysengerät zur Online-Bestimmung der Abgaszusammensetzung (21) geführt. Die Menge an zugeführtem Reaktionsgas und Verdünnungsgas wird über Messgeräte (15) erfasst und zusammen mit der Abgaszusammensetzung an eine Rechnereinheit (22) zur Steuerung der Zugabe an Siliciumkeimpartikeln und zum Abzug von Produktgranulat weitergeleitet.

Die Siliciumkeimpartikel (23) können über eine Dosiervorrichtung (24) und ein Zuführrohr (25) in den Gasraum (20) des Reaktors dosiert werden und fallen von dort nach unten in die Wirbelschicht (2). Siliciumgranulat (26) wird über ein Abzugsrohr (27) und eine Dosiervorrichtung (28)aus der unteren Zone (5) der Wirbelschicht abgezogen und über den Reaktorboden (37) aus dem Reaktor geführt.

BEISPIEL 1: Prozess A (Ideale Prozessführung)

In einem Reaktor mit einem Durchmesser von 400 mm bei einer Verdünnungsgasmenge von 120 Nm3/h Wasserstoff durch die untere Zone, einer Reaktionsgasmenge von 44 Nm3/h Wasserstoff und 240 kg/h Trichlorsilan, einer Jetgeschwindigkeit im Austritt der Reaktionsgasdüse von 60 m/s, einem Reaktordruck von 1,4 bar Überdruck, einer Betttemperatur von 960°C, einer Partikelgrößenverteilung zwischen 150 $\mu$m und 7000 $\mu$m mit einem Sauterdurchmesser $d_{32}$ von 950 $\mu$m und einer elektrischen Heizerleistung von 120 kW wurde folgendes Ergebnis erreicht. Es wurde über 9 kg/h Siliciumgranulat in für Solaranwendungen geeigneter Qualität abgeschieden. Mit dieser Reaktionsführung wurde hiermit ein Reaktionsumsatz von größer 85 % des chemischen Gleichgewichtsumsatzes erreicht. Die Wandabscheidung im Bereich der Wirbelschicht lag dabei unter 0,05 %, die Staubbildung durch homogene Gasphasenreaktion unter 2 %. Staubanteile im Abgasstaub durch Abrieb konnten nicht nachgewiesen werden. Mit einer Reaktorlaufzeit von 4 Wochen und einer Produktion von mehr als 5 t konnte die Eignung des Heiz- und Prozesskonzeptes nachgewiesen werden.

VERGLEICHSBEISPIEL 1: (Reaktionsgas zu schnell)

In einem Reaktor mit einem Durchmesser von 400 mm bei einer Verdünnungsgasmenge von 100 Nm3/h Wasserstoff durch die untere Zone, einer Reaktionsgasmenge von 44 Nm3/h Wasserstoff und 240 kg/h Trichlorsilan, einer Jetgeschwindigkeit im Austritt der Reaktionsgasdüse von 120 m/s, einem Reaktordruck von 1,0 bar Überdruck, einer Betttemperatur von 960°C, einer Partikelgrößenverteilung zwischen 150 $\mu$m und 7000 $\mu$m mit einem Sauterdurchmesser $d_{32}$ von 950 $\mu$m und einer elektrischen Heizerleistung von 114 kW wurde folgendes Ergebnis erreicht. Es wurde über 7 kg/h Siliciumgranulat in für Solaranwendungen geeigneter Qualität abgeschieden. Eine Analyse des Abgasstaubes ergab, dass der Anteil an Abrieb bei diesem Prozess sehr hoch ist, er lag bei 18 %, da es durch die hohen Gasaustrittsgeschwindigkeiten (bedingt durch den niedrigeren Druck im Vergleich zu Prozess A) an der Reaktionsgasdüse zu Mahleffekten durch Partikelkollisionen kommt.

VERGLEICHSBEISPIEL 2: (Reaktionsgas zu langsam)

In einem Reaktor mit einem Durchmesser von 400 mm bei einer Verdünnungsgasmenge von 120 Nm3/h Wasserstoff durch die untere Zone, einer Reaktionsgasmenge von 34 Nm3/h Wasserstoff in einem Ringspalt 10 Nm3/h Wasserstoff und 200 kg/h Trichlorsilan in der zentralen Reaktionsgasdüse, einer Jetgeschwindigkeit im Austritt der Reaktionsgasdüse von 20 m/s, einem Reaktordruck von 1,4 bar Überdruck, einer Betttemperatur von 960°C, einer Partikelgrößenverteilung zwischen 150 $\mu$m und 7000 $\mu$m mit einem Sauterdurchmesser $d_{32}$ von 950 $\mu$m und einer elektrischen Heizerleistung von 110 kW wurde folgendes Ergebnis erreicht. Es wurde über 6,5 kg Siliciumgranulat pro Stunde in für Solaranwendungen geeigneter Qualität abgeschieden. Die Wandabscheidung im Bereich der Wirbelschicht lag dabei über 3 % und die Staubbildung durch homogene Gasphasenreaktion über 15 %. Eine Analyse des Abgasstaubes ergab, dass der Anteil an Abrieb vernachlässigbar klein ist und es sich nur um amorphe Staubbildung handelt. Es wurde messtechnisch ermittelt, dass es bei der gewählten Reaktionsgasgeschwindigkeit zu Feststoffzirkulationswalzen kommt, die zu einer Verschleppung von Reaktionsgas an heiße Reaktorwandflächen führt. Dieses Reaktionsgas scheidet sich dann auf den heißen Reaktoroberflächen ab. Ein zusätzliches Problem bei diesem Prozess war ein unerwünscht hoher Anteil an homogener Gasphasenreaktion dessen Ursache in lokal sehr hohen Molanteilen Chlorsilan lag.

VERGLEICHSBEISPIEL 3: (zu viel Bodengas)

In einem Reaktor mit einem Durchmesser von 400 mm bei einer Fluidisiergasmenge von 240 Nm3/h, Reaktionsgasmenge von 44 Nm3/h Wasserstoff und 240 kg/h Trichlorsilan, einer Jetgeschwindigkeit im Austritt der Reaktionsgasdüse von 60 m/s, einem Reaktordruck von 1,4 bar Überdruck, einer Betttemperatur von 960°C, einer Partikelgrößenverteilung zwischen 150 $\mu$m und 7000 $\mu$m mit einem Sauterdurchmesser $d_{32}$ von 950 $\mu$m und einer elektrischen Heizerleistung von 145 kW wurde folgendes Ergebnis erreicht. Es wurden 5 kg Siliciumgranulat pro Stunde abgeschieden. Die Wandabscheidung im Bereich der Wirbelschicht lag dabei bei 1 %, die Staubbildung durch homogene Gasphasenreaktion bei 21 %. Eine Analyse des Abgasstaubes ergab, dass der Anteil an Abrieb bei ca. 9 % und an amorpher Staubbildung bei ca. 14 % lag. Eine hohe Menge an Fluidisiergas führte bei diesem Prozess zu einer stark anwachsenden Gasblasengröße, die in ihrem Durchmesser dem Reaktorquerschnitt entsprach. Durch den großen Blasendurchmesser kam es zum Aufwerfen von Granulatmengen und damit zu mechanischen Erschütterungen. Neben der enormen mechanischen Belastung des Apparates konnte auch ein Bruch und Abrieb von Granulatpartikeln und damit ein Absinken der Sphärizität im Siliciumgranulat unter 0,9 festgestellt werden. Da in der Blase kein Kontakt des Reaktionsgases mit der Granulatoberfläche möglich ist, finden eine erhöhte homogene Gasphasenabscheidung und ein verschlechterter Reaktionsgasumsatz statt. Durch die geringere Abscheiderate, den erhöhten Staubanfall und die verringerte Reaktorlaufzeit ist eine wirtschaftlich sinnvolle Produktion von Siliciumgranulat mit einem solchen Prozess nicht möglich.

VERGLEICHSBEISPIEL 4: (wenig Bodengas; Strahlwirbelschicht)

In einem Reaktor mit einem Durchmesser von 400 mm bei einer Fluidisiergasmenge von 90 Nm3/h, Reaktionsgasmenge von 44 Nm3/h Wasserstoff und 240 kg/h Trichlorsilan, einer Jetgeschwindigkeit im Austritt der Reaktionsgasdüse von 60 m/s, einem Reaktordruck von 1,4 bar Überdruck, einer Betttemperatur von 960°C, einer Partikelgrößenverteilung zwischen 150 $\mu$m und 7000 $\mu$m mit einem Sauterdurchmesser $d_{32}$ von 950 $\mu$m und einer elektrischen Heizerleistung von 110 kW wurde folgendes Ergebnis erreicht. Es wurden über 8 kg Siliciumgranulat pro Stunde in für Solaranwendungen geeigneter Qualität abgeschieden. Die Wandabscheidung im Bereich der Wirbelschicht lag dabei unter 0,5 %, die Staubbildung durch homogene Gasphasenreaktion unter 10 %. Nach einer Reaktorlaufzeit von 2 Tagen verformte sich die Reaktorwand wegen einer lokalen Temperaturüberhitzung und der Reaktor musste abgestellt werden. Eine Analyse ergab, dass aufgrund der geringen Bodengasmenge die Bewegung des Siliciumgranulates im Randbereich der Wirbelschicht stagnierte und es dadurch zu der lokalen Überhitzung kam, wobei das Granulat versinterte. Im Zentrum bildete sich eine Strahlwirbelschicht aus. Der Reaktor kann mit diesem Prozess nicht über längere Zeit stabil und damit wirtschaftlich betrieben werden.

**Patentansprüche**

1.  Verfahren zur Herstellung von hochreinem Polysiliciumgranulat durch Abscheidung eines Reaktionsgases an Siliciumgranulat in einem Wirbelschichtreaktor, umfassend:

    (I) einen Reaktor mit einem Reaktorraum bestehend aus mindestens zwei hintereinander liegenden Zonen,
    (II) wobei die untere Zone, die eine Höhe von 50 bis 300 mm aufweist, durch die Einleitung eines Silicium-freien Gases mittels Einzeldüsen bei einer Austrittgeschwindigkeit von 20 bis 200 m/s in das Siliciumgranulat schwach fluidisiert wird, wobei die Gasgeschwindigkeit in der unteren Zone das 1,2 bis 2,3-fache der Lockerungsgasgeschwindigkeit beträgt;
    (III) wobei daran in direktem Kontakt eine weitere Zone angeschlossen ist, die in direktem Kontakt mit der ersten Zone steht
    (IV) diese Zone über deren nach außen begrenzende Wandung beheizt wird, und
    (V) in die dort gebildete Reaktionszone ein siliciumhaltiges Reaktionsgas mittels einer oder mehrerer Düsen mit einer Geschwindigkeit von 1 bis 140 m/s als vertikal nach oben gerichteter Gasstrahl eingedüst wird, wobei sich oberhalb der Düsen lokale Reaktionsgasstrahlen umgeben von blasenbildender Wirbelschicht bilden, innerhalb derer sich das siliciumhaltige Gas an den Partikeloberflächen zersetzt und zum Partikelwachstum führt, und
    (VI) das Reaktionsgas dabei in der Art eingeleitet wird, dass es nahezu bis zum chemischen Gleichgewichtsumsatz abreagiert ist, bevor es entweder die Wirbelschichtbewandung oder die Wirbelschichtoberfläche erreicht.

2.  Verfahren nach Anspruch 1, **dadurch gekennzeichnet, dass** als Reaktionsgas ein oder mehrere siliciumhaltige Gase der allgemeinen Verbindung $SiH_xCl_y$ oder Mischungen dieser Gase mit einem oder mehreren siliciumfreien Gasen aus der Gruppe enthaltend, Wasserstoff, Stickstoff und Argon, als Verdünnungsgas eingesetzt werden.

3.  Verfahren nach Anspruch 1 oder 2, **dadurch gekennzeichnet, dass** als Reaktionsgas $SiH_4$, $SiCl_4$ oder $SiHCl_3$ verdünnt mit Wasserstoff eingesetzt wird.

4.  Verfahren nach Anspruch 1 bis 3, **dadurch gekennzeichnet, dass** der Molanteil an Trichlorsilan im Reaktionsgas im Bereich von 0,2 bis 0,8 liegt.

5.  Verfahren nach Anspruch 1 bis 4, **dadurch gekennzeichnet, dass** der mittlere Molanteil zusammen mit dem Verdünnungsgas aus der unteren Zone über den gesamten Reaktorquerschnitt im Bereich von 0,15 bis 0,4 liegt.

6.  Verfahren nach Anspruch 1 bis 5, **dadurch gekennzeichnet, dass** in der Reaktionszone die mittlere Gasgeschwindigkeit im Bereich der 2 bis 8-fachen Lockerungsgasgeschwindigkeit liegt.

7.  Verfahren nach Anspruch 1 bis 6, **dadurch gekennzeichnet, dass** der Mindestabstand der Düsen zueinander so gewählt wird, dass das Verhältnis aus Düsenabstand (horizontaler Abstand zwischen den Strahlachsen) zu Düsendurchmesser (Innendurchmesser der Düse am Ort des Gasaustrittes in die Wirbelschicht) größer als 7,5 ist.

8.  Verfahren nach Anspruch 1 bis 7, **dadurch gekennzeichnet, dass** die Austrittsgeschwindigkeit an einer Ringdüse kleiner ist als die Austrittsgeschwindigkeit an einer zentralen Düse.

9.  Verfahren nach Anspruch 8, **dadurch gekennzeichnet, dass** die Geschwindigkeit an der Ringdüse im Bereich $0,4*v_{zentraldüse} < v_{Ringdüse} < 0,8* v_{Zentraldüse}$ liegt.

10. Verfahren nach Anspruch 1 bis 9, **dadurch gekennzeichnet, dass** die Verweilzeit der Gase in der oberen Zone der Wirbelschicht im Bereich von 0,1 bis 10 Sekunden liegt.

11. Verfahren nach Anspruch 1 bis 10, **dadurch gekennzeichnet, dass** die Betttemperatur der Wirbelschicht im Bereich von 890 bis 1400°C liegt.

12. Verfahren nach Anspruch 1 bis 11, **dadurch gekennzeichnet, dass** der Reaktordruck im Bereich von 0 bis 7 bar Überdruck liegt.

**13.** Verfahren nach Anspruch 1 bis 12, **dadurch gekennzeichnet, dass** der Betrieb der Wirbelschicht eine stationäre Korngrößenverteilung aufweist, wobei die Partikel zwischen 150 und 7000 μm groß sind und der Sauterdurchmesser der Verteilung im Bereich 850 bis 1500 μm liegt.

**14.** Verfahren nach Anspruch 1 bis 13, **dadurch gekennzeichnet, dass** eine Online-Abgasanalytik zur Bestimmung des Reaktionsumsatzes verwendet wird, wobei in Kombination mit der Erfassung der Mengen an zugeführtem Reaktions- und Verdünnungsgas und einem Rechenmodell zur Partikelpopulation die Zugabe der Keimpartikel und der Produktabzug so gesteuert werden kann, dass die gewünschte Korngrößenverteilung im Reaktor und die Menge an Granulat in der Wirbelschicht über einen langen Zeitraum hinweg stabil und stationär gehalten werden kann.

**15.** Verfahren nach Anspruch 1 bis 14, **dadurch gekennzeichnet, dass** der Untergrößenanteil an Partikel kleiner 150 μm bei unter 0,1 Massenprozent liegt, ohne dass ein zusätzlicher Klassierungsschritt notwendig ist.

**16.** Verfahren nach Anspruch 1 bis 15, **dadurch gekennzeichnet, dass** das abgeschiedene Polysiliciumgranulat eine ausgesprochen kugelige Form mit Sphärizitätswerten im Bereich von 0,85 bis 1 [-] besitzt.

**Claims**

**1.** Process for the production of high-purity polysilicon granules by depositing a reaction gas on silicon granules in a fluidized bed reactor, comprising:

(I) a reactor having a reactor space comprising at least two zones lying one behind another,
(II) wherein the lower zone, which has a height of 50 to 300 mm, is weakly fluidized by the introduction of a silicon-free gas into the silicon granules by means of individual nozzles at an exit velocity of 20 to 200 m/s, wherein the gas velocity in the lower zone is 1.2 to 2.3 times the minimum fluidization velocity;
(III) wherein a further zone is connected thereto in direct contact, said further zone being in direct contact with the first zone,
(IV) this zone is heated via its outwardly bounding wall, and
(V) a silicon-containing reaction gas is introduced as a vertically upwardly directed gas jet into the reaction zone formed there by means of one or a plurality of nozzles at a velocity of 1 to 140 m/s, wherein above the nozzles local reaction gas jets surrounded by bubble-forming fluidized bed form, within which the silicon-containing gas decomposes at the particle surfaces and leads to the particle growth, and
(VI) in this case the reaction gas is introduced in such a way that it has almost fully reacted to chemical equilibrium conversion before it reaches either the fluidized bed wall or the fluidized bed surface.

**2.** Process according to Claim 1, **characterized in that** as reaction gas use is made of one or more silicon-containing gases of the general compound $SiH_xCl_y$ or mixtures of said gases with one or more silicon-free gases from the group containing hydrogen, nitrogen and argon, as dilution gas.

**3.** Process according to Claim 1 or 2, **characterized in that** $SiH_4$, $SiCl_4$ or $SiHCl_3$ diluted with hydrogen is used as reaction gas.

**4.** Process according to Claims 1 to 3, **characterized in that** the molar fraction of trichlorosilane in the reaction gas lies within the range 0.2 to 0.8.

**5.** Process according to Claims 1 to 4, **characterized in that** the average molar fraction together with the dilution gas from the lower zone over the entire reactor cross section lies within the range 0.15 to 0.4.

**6.** Process according to Claims 1 to 5, **characterized in that** in the reaction zone the average gas velocity lies within the range of 2 to 8 times the minimum fluidization velocity.

**7.** Process according to Claims 1 to 6, **characterized in that** the minimum distance between the nozzles is chosen such that the ratio of nozzle distance (horizontal distance between the jet axes) to nozzle diameter (internal diameter of the nozzle at the location of the gas exit into the fluidized bed) is greater than 7.5.

8. Process according to Claims 1 to 7, **characterized in that** the exit velocity at a ring nozzle is less than the exit velocity at a central nozzle.

9. Process according to Claim 8, **characterized in that** the velocity at the ring nozzle lies within the range of $0.4 \cdot v_{central}$ nozzle $< v_{ring}$ nozzle $< 0.8\ v_{central}$ nozzle.

10. Process according to Claims 1 to 9, **characterized in that** the residence time of the gases in the upper zone of the fluidized bed lies within the range 0.1 to 10 seconds.

11. Process according to Claims 1 to 10, **characterized in that** the bed temperature of the fluidized bed lies within the range of 890 to 1400°C.

12. Process according to Claims 1 to 11, **characterized in that** the reactor pressure lies within the range of 0 to 7 bar excess pressure.

13. Process according to Claims 1 to 12, **characterized in that** the operation of the fluidized bed has a steady-state grain size distribution, wherein the size of the particles is between 150 and 7000 $\mu$m, and the Sauter diameter of the distribution lies within the range of 850 to 1500 $\mu$m.

14. Process according to Claims 1 to 13, **characterized in that** an online exhaust gas analysis system is used for determining the reaction conversion, wherein in combination with the detection of the amounts of reaction and dilution gas fed and a computational model for the particle population, the addition of the seed particles and the product take-off can be controlled such that the desired grain size distribution in the reactor and the amount of granules in the fluidized bed can be kept stable and in the steady state over a long period of time.

15. Process according to Claims 1 to 14, **characterized in that** the undersized fraction of particles smaller than 150 $\mu$m is less than 0.1 per cent by mass, without an additional classification step being necessary.

16. Process according to Claims 1 to 15, **characterized in that** the deposited polysilicon granules have a markedly spherical shape with sphericity values within the range of 0.85 to 1 [-].

## Revendications

1. Procédé pour la production de granulés de polysilicium très pur par dépôt d'un gaz de réaction sur un granulé de silicium dans un réacteur à couche tourbillonnaire, comprenant :

(I) un réacteur comportant une chambre de réacteur consistant en au moins deux zones placées l'une derrière l'autre,

(II) la zone inférieure, qui présente une hauteur de 50 à 300 mm, étant légèrement fluidisée par le passage dans le granulé de silicium d'un gaz exempt de silicium introduit au moyen de buses simples à une vitesse de sortie de 20 à 200 m/s, la vitesse du gaz dans la zone inférieure représentant 1,2 à 2,3 fois la vitesse minimale de fluidisation ;

(III) en contact direct avec celle-ci y faisant suite une autre zone qui est en contact direct avec la première zone

(IV) cette zone étant chauffée par la paroi la séparant de l'extérieur, et

(V) dans la zone de réaction qui y est formée, un gaz de réaction contenant du silicium est injecté sous forme de jet de gaz dirigé verticalement vers le haut, au moyen d'une ou plusieurs buses, à une vitesse de 1 à 140 m/s, au-dessus des buses se formant des jets locaux de gaz de réaction, entourés d'une couche tourbillonnaire génératrice de bulles, à l'intérieur de laquelle le gaz contenant du silicium se décompose à la surface des particules et conduit à la croissance des particules, et

(VI) le gaz de réaction est pour cela introduit de manière à presque complètement réagir jusqu'à la conversion à l'équilibre chimique avant d'atteindre soit la limite de la couche tourbillonnaire, soit la surface de la couche tourbillonnaire.

2. Procédé selon la revendication 1, **caractérisé en ce qu'**on utilise comme gaz de réaction un ou plusieurs gaz contenant du silicium, de formule générale $SiH_xCl_y$, ou des mélanges de ces gaz avec un ou plusieurs gaz exempt (s) de silicium choisi(s) dans le groupe contenant l'hydrogène, l'azote et l'argon, en tant que gaz de dilution.

**3.** Procédé selon la revendication 1 ou 2, **caractérisé en ce qu'**on utilise comme gaz de réaction $SiH_4$, $SiCl_4$ ou $SiHCl_3$, dilué avec de l'hydrogène.

**4.** Procédé selon l'une quelconque des revendications 1 à 3, **caractérisé en ce que** la proportion molaire de trichlorosilane dans le gaz de réaction se situe dans la plage allant de 0,2 à 0,8.

**5.** Procédé selon l'une quelconque des revendications 1 à 4, **caractérisé en ce que** la proportion molaire moyenne, conjointement avec le gaz de dilution provenant de la zone inférieure, sur la section transversale totale du réacteur, se situe dans la plage allant de 0,15 à 0,4.

**6.** Procédé selon l'une quelconque des revendications 1 à 5, **caractérisé en ce que**, dans la zone de réaction, la vitesse moyenne du gaz se situe dans la plage allant de 2 à 8 fois la vitesse minimale de fluidisation.

**7.** Procédé selon l'une quelconque des revendications 1 à 6, **caractérisé en ce que** l'écartement minimum des buses entre elles est choisi de manière à ce que le rapport de l'écartement des buses (distance horizontale entre les axes des jets) au diamètre des buses (diamètre interne de la buse à l'endroit de la sortie du gaz dans la couche tourbillonnaire) soit supérieur à 7,5.

**8.** Procédé selon l'une quelconque des revendications 1 à 7, **caractérisé en ce que** la vitesse de sortie au niveau d'une buse annulaire est inférieure à la vitesse de sortie au niveau d'une buse centrale.

**9.** Procédé selon la revendication 8, **caractérisé en ce que** la vitesse au niveau de la buse annulaire se situe dans la plage $0,4*V_{buse\ centrale} < V_{buse\ annulaire} < 0,8\ *V_{buse\ centrale}$.

**10.** Procédé selon l'une quelconque des revendications 1 à 9, **caractérisé en ce que** le temps de séjour des gaz dans la zone supérieure de la couche tourbillonnaire se situe dans la plage allant de 0,1 à 10 secondes.

**11.** Procédé selon l'une quelconque des revendications 1 à 10, **caractérisé en ce que** la température de lit de la couche tourbillonnaire se situe dans la plage allant de 890 à 1 400 °C.

**12.** Procédé selon l'une quelconque des revendications 1 à 11, **caractérisé en ce que** la pression dans le réacteur se situe dans la plage allant de 0 à 7 bars de surpression.

**13.** Procédé selon l'une quelconque des revendications 1 à 12, **caractérisé en ce que** le fonctionnement de la couche tourbillonnaire présente une distribution granulométrique stationnaire, les particules ayant une taille comprise entre 150 et 7 000 $\mu$m et le diamètre de Sauter de la distribution se situant dans la plage allant de 850 à 1 500 $\mu$m.

**14.** Procédé selon l'une quelconque des revendications 1 à 13, **caractérisé en ce qu'**on utilise une analyse en ligne des gaz rejetés pour la détermination du degré d'avancement de la réaction, en association avec la détermination des quantités de gaz de réaction et de gaz de dilution introduits et avec un modèle de calcul de la population de particules, l'addition des particules germes et la décharge du produit pouvant être régulées de manière à pouvoir maintenir stables et stationnaires pendant une longue durée la distribution granulométrique désirée dans le réacteur et la quantité de granulés dans la couche tourbillonnaire.

**15.** Procédé selon l'une quelconque des revendications 1 à 14, **caractérisé en ce que** la proportion de particules de taille inférieure à 150 $\mu$m est inférieure à 0,1 % en masse, sans qu'une étape supplémentaire de classification soit nécessaire.

**16.** Procédé selon l'une quelconque des revendications 1 à 15, **caractérisé en ce que** le granulé de polysilicium déposé a une forme nettement sphérique, avec des valeurs de la sphéricité dans la plage allant de 0,85 à 1 [-].

Figur 1:

**EP 1 990 314 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 3963838 A
- JP 2279513 A
- US 4992245 A
- US 5374413 A
- DE 19948395
- US 6827786 B
- DE 19948395 A1

- EP 0896952 A
- WO 2004013044 A
- US 6827786 F
- US 5810934 A
- US 5798137 A
- US 7029632 B